# EUROPEAN PATENT APPLICATION

(11) **EP 4 641 904 A1**
(43) Date of publication of application: **29.10.2025**
(21) Application number: 22968746.2
(22) Date of filing: 21.12.2022
(51) Int. Cl.: H02M 3/155

(54) **POWER-SUPPLY CIRCUIT AND POWER-SUPPLY SYSTEM**

(71) Applicant: JTEKT Corporation, Kariya-shi, Aichi 448-8652 (JP)
(72) Inventor: SUZUKI, Takashi, Kariya-shi, Aichi 448-8652 (JP); TAKAHASHI, Toshihiro, Kariya-shi, Aichi 448-8652 (JP); ABE, Kenichi, Kariya-shi, Aichi 448-8652 (JP); KAJISAWA, Yuuta, Kariya-shi, Aichi 448-8652 (JP); HIBI, Motoaki, Kariya-shi, Aichi 448-8652 (JP); MIO, Takumi, Kariya-shi, Aichi 448-8652 (JP); SHINODA, Satoshi, Kariya-shi, Aichi 448-8652 (JP); HIBINO, Tokuaki, Kariya-shi, Aichi 448-8652 (JP); SATO, Fumihiko, Kariya-shi, Aichi 448-8652 (JP); OTA, Kohei, Kariya-shi, Aichi 448-8652 (JP); NITTA, Hiroki, Kariya-shi, Aichi 448-8652 (JP)
(74) Representative: Winter, Brandl - Partnerschaft mbB
(86) International application number: PCT/JP2022/047167
(87) International publication number: WO 2024/134807

(57) **Abstract**

A power supply circuit (70) includes a power conversion circuit (72). A terminal voltage of a first direct-current voltage source (60) and a terminal voltage of a second direct-current voltage source (82) are applied to the power conversion circuit. The power supply circuit includes a bypass path. The bypass path is a path that bypasses the power conversion circuit and connects the first direct-current voltage source and an electrical load, and includes a switch (76) that opens and closes the path.

## Description

### TECHNICAL FIELD

The present disclosure relates to a power supply circuit and a power supply system.

### BACKGROUND ART

For example, Patent Document 1 below describes a power conversion circuit that receives a terminal voltage of a first direct-current voltage source and a terminal voltage of a second direct-current voltage source. In this power conversion circuit, a switching element for use in a process of converting the terminal voltage of the first direct-current voltage source and a switching element for use in a process of converting the terminal voltage of the second direct-current voltage source are shared. With this power conversion circuit, even if an abnormality occurs in one of the two voltage sources that are the first direct-current voltage source and the second direct-current voltage source, electric power can be supplied to an electrical load using the other one.

### Related Art Documents

### Patent Documents

Patent Document 1: Japanese Patent No. 5492040 (JP 5492040 B)

### SUMMARY OF THE INVENTION

### Problem to be Solved by the Invention

In the case of the above power conversion circuit, if an abnormality occurs in the switching element, there is a risk that neither the first direct-current voltage source nor the second direct-current voltage source can supply electric power to the electrical load.

### Means for Solving the Problem

In one aspect of the present disclosure, a power supply circuit is provided. A power supply circuit includes: a power conversion circuit configured to apply an output voltage to an electrical load; and a bypass path. The power conversion circuit is configured such that a terminal voltage of a first direct-current voltage source and a terminal voltage of a second direct-current voltage source are applied, and includes a first inductor, a second inductor, and a plurality of switching elements. The plurality of switching elements is configured to open and close a first loop path, a second loop path, a third loop path, and a fourth loop path. The plurality of switching elements that opens and closes the first loop path and the second loop path and the plurality of switching elements that opens and closes the third loop path and the fourth loop path are common elements. The first loop path is a path that includes the first direct-current voltage source and the first inductor and does not include an output terminal of the power conversion circuit. The second loop path is a path that includes the first direct-current voltage source, the first inductor, and the output terminal of the power conversion circuit. The third loop path is a path that includes the second direct-current voltage source and the second inductor and does not include the output terminal of the power conversion circuit. The fourth loop path is a path that includes the second direct-current voltage source, the second inductor, and the output terminal of the power conversion circuit. The bypass path is a path that bypasses the power conversion circuit and connects the first direct-current voltage source and the electrical load, and includes a switch that opens and closes the bypass path.

### BRIEF DESCRIPTION OF THE DRAWINGS

[FIG. 1] FIG. 1 is a diagram showing the configuration of an in-vehicle system according to a first embodiment.
[FIG. 2] FIG. 2 is a circuit diagram showing the configuration of a power supply circuit in the in-vehicle system in FIG. 1.
[FIGS. 3] FIGS. 3A and 3B are circuit diagrams showing a power conversion process in which electric power of a battery is input.
[FIGS. 4] FIGS. 4A and 4B are circuit diagrams showing a power conversion process in which electric power of a capacitor is input.
[FIG. 5] FIG. 5 is a time chart illustrating operations of the power supply circuit according to the first embodiment.
[FIG. 6] FIG. 6 is a time chart showing an example of control on an output voltage of a second power conversion circuit according to the first embodiment.
[FIG. 7] FIG. 7 is a diagram showing the configuration of an in-vehicle system according to a second embodiment.
[FIG. 8] FIG. 8 is a circuit diagram showing the configuration of a power supply circuit in the in-vehicle system in FIG. 7.

### MODES FOR CARRYING OUT THE INVENTION

### <First Embodiment>

A first embodiment will be described below with reference to the drawings.

### "Overall Configuration"

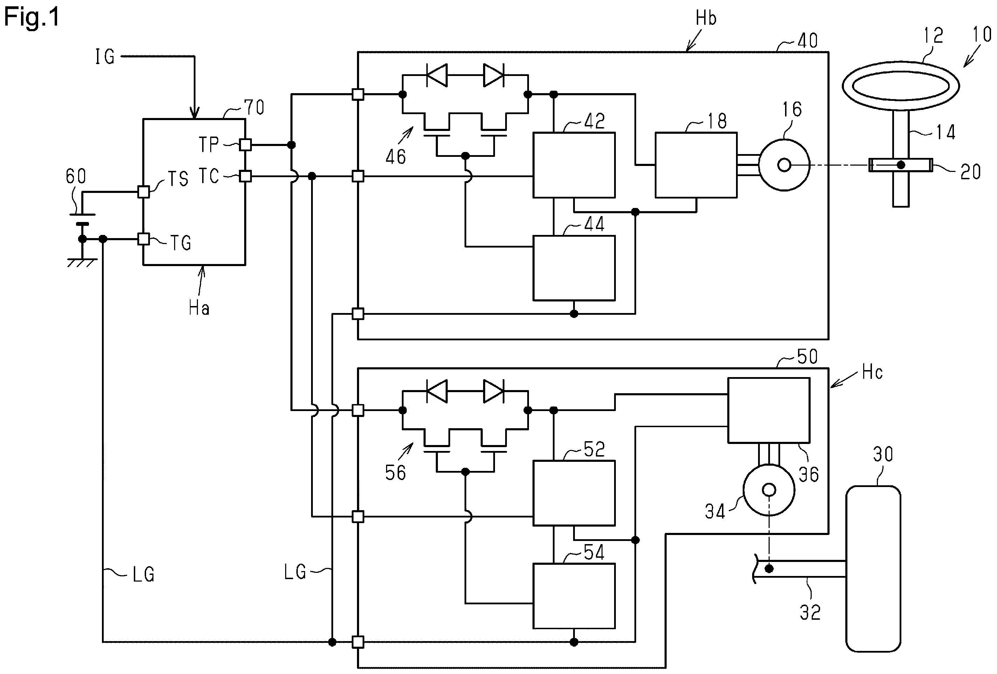

FIG. 1 shows the configuration of a power supply system according to the present embodiment.

As shown in FIG. 1, a steering device 10 of a vehicle according to the present embodiment includes a steering wheel 12, a steering shaft 14, a reaction motor 16, a reaction inverter 18, and a reaction reduction mechanism 20. The steering shaft 14 is connected to the steering wheel 12. The reaction motor 16 applies a steering reaction force that is a force resisting steering to the steering wheel 12 via the steering shaft 14. The reaction motor 16 is connected to the steering shaft 14 via the reaction reduction mechanism 20. For example, a three-phase synchronous motor is adopted as the reaction motor 16. The reaction inverter 18 is a direct current-to-alternating current conversion circuit that converts a voltage of a direct-current voltage source into an alternating-current voltage and applies it to the reaction motor 16. The reaction reduction mechanism 20 is composed, for example, of a worm and a wheel.

The steering device 10 includes a steered wheel 30, a rack shaft 32, a steering motor 34, and a steering inverter 36. The turning angle of a tire of the steered wheel 30 is changed by axial displacement of the rack shaft 32. The rack shaft 32 is displaced in the axial direction as the steering motor 34 rotates. For example, a three-phase synchronous motor is adopted as the steering motor 34. The steering inverter 36 is a direct current-to-alternating current conversion circuit that converts a voltage of a direct-current voltage source into an alternating-current voltage and applies it to the steering motor 34.

The reaction motor 16 and the reaction inverter 18 are housed in a housing Hb of a reaction force control unit 40. The steering wheel 12 is a controlled object of the reaction force control unit 40. That is, the reaction force control unit 40 controls a steering reaction force that resists steering by a driver and is a controlled variable for the steering wheel 12 that is the controlled object.

The reaction force control unit 40 includes a reaction power supply IC 42 and a reaction microcomputer 44. The reaction power supply IC 42 is an integrated circuit that supplies electric power to the reaction microcomputer 44 when an IG signal is turned ON. When the reaction microcomputer 44 is turned ON, a reaction power supply relay 46 is turned ON. That is, when the IG signal is turned ON, the reaction microcomputer 44 closes the reaction power supply relay 46.

The IG signal is a traveling permission signal for the vehicle. The traveling permission signal is a signal for switching the vehicle to a travelable state. For example, in a case of a vehicle including only an internal combustion engine as its thrust generating device, the traveling permission signal is an ignition signal. In a case where the thrust generating device of the vehicle is a motor, the traveling permission signal may be a signal for switching a relay provided between the motor and a battery to a closed state.

The reaction power supply relay 46 is, for example, a field effect transistor. In particular, FIG. 1 shows an example in which the reaction microcomputer 44 is connected to a cathode of a body diode.

The reaction microcomputer 44 is a control circuit that operates the reaction inverter 18 to control a reaction torque to be applied to the steering wheel 12. The steering motor 34 and the steering inverter 36 are housed in a housing Hc of a steering control unit 50. The steered wheel 30 is a controlled object of the steering control unit 50. That is, the steering control unit 50 controls the turning angle of the tire of the steered wheel 30 that is the controlled object.

The steering control unit 50 includes a steering power supply IC 52 and a steering microcomputer 54. The steering power supply IC 52 is an integrated circuit that supplies electric power to the steering microcomputer 54 when the IG signal is turned ON. When the steering microcomputer 54 is turned ON, a steering power supply relay 56 is turned ON.

The steering power supply relay 56 is, for example, a field effect transistor. In particular, FIG. 1 shows an example in which the steering microcomputer 54 is connected to a cathode of a body diode.

The steering microcomputer 54 is a control circuit that operates the steering inverter 36 to control a torque of the steering motor 34. The reaction force control unit 40 and the steering control unit 50 are supplied with electric power from a battery 60 via a power supply circuit 70. The battery 60 is a secondary battery such as a lead storage battery, a nickel-metal hydride secondary battery, or a lithium-ion secondary battery. The terminal voltage of the battery 60 may be, for example, several volts to several tens of volts. The terminal voltage of the battery 60 may be more than 10 volts.

The power supply circuit 70 includes a power terminal TP and a control terminal TC. The power terminal TP is a terminal for supplying electric power to an actuator system. That is, the power terminal TP is a terminal for supplying electric power to the reaction inverter 18 and the steering inverter 36. The control terminal TC is a terminal for supplying electric power to a control unit that operates the actuator system. That is, the control terminal TC is a terminal for supplying electric power to the reaction power supply IC 42, the reaction microcomputer 44, the steering power supply IC 52, and the steering microcomputer 54.

That is, the reaction power supply IC 42 and the steering power supply IC 52 are supplied with electric power from the control terminal TC. The reaction power supply IC 42 can be supplied with electric power from the power terminal TP via the reaction power supply relay 46. The steering power supply IC 52 can be supplied with electric power from the power terminal TP via the steering power supply relay 56.

The reaction inverter 18 can be supplied with electric power from the power terminal TP via the reaction power supply relay 46. The steering inverter 36 can be supplied with electric power from the power terminal TP via the steering power supply relay 56.

The positive terminal of the battery 60 is connected to a power supply terminal TS of the power supply circuit 70. The negative terminal of the battery 60 is connected to a ground terminal TG of the power supply circuit 70. The negative terminal of the battery 60 is also connected to the reaction force control unit 40 and the steering control unit 50 via a ground line LG that bypasses the power supply circuit 70. The ground line LG is present outside a housing Ha that houses the power supply circuit 70, the housing Hb that houses the reaction force control unit 40, and the housing Hc that houses the steering control unit 50. The ground line LG may be, for example, a cable having an insulating coating.

### "Regarding Power Supply Circuit"

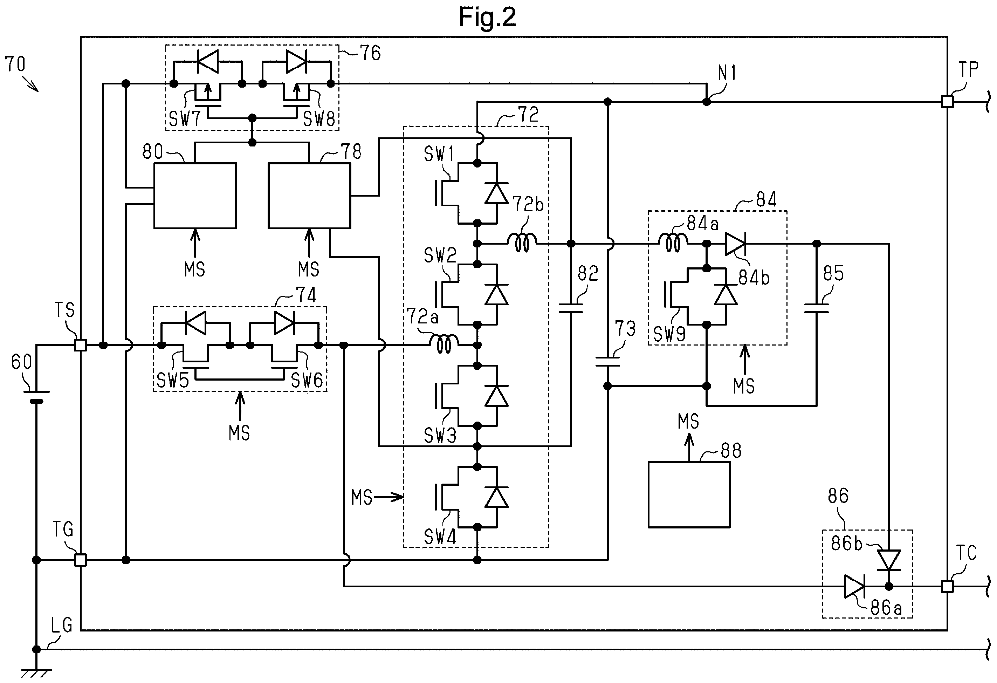

FIG. 2 shows the configuration of the power supply circuit 70. The power supply circuit 70 includes a first power conversion circuit 72. The first power conversion circuit 72 includes a series connection of four switching elements SW1 to SW4. A terminal that is not connected to the switching element SW2 out of two input-output terminals of the switching element SW1 is an output terminal of the first power conversion circuit 72. A terminal that is not connected to the switching element SW3 out of two input-output terminals of the switching element SW4 is connected to the ground terminal TG.

All the switching elements SW1 to SW4 are field effect transistors. A body diode is formed in each of the switching elements SW1 to SW4. The forward direction of the body diode is a direction from the ground terminal TG side to the output side of the first power conversion circuit 72. The first power conversion circuit 72 includes a first inductor 72a connected to a connection point between the switching element SW2 and the switching element SW3. The first power conversion circuit 72 further includes a second inductor 72b connected to a connection point between the switching element SW1 and the switching element SW2.

A terminal that is not connected to the connection point between the switching element SW2 and the switching element SW3 out of two terminals of the first inductor 72a is connected to a power supply relay 74. The power supply relay 74 opens and closes the point between the power supply terminal TS and the first power conversion circuit 72. The power supply relay 74 is a normally open relay. The power supply relay 74 is formed by a series connection of two switching elements SW5, SW6. The switching elements SW5, SW6 are, for example, field effect transistors. In particular, FIG. 2 shows an example in which the anodes of body diodes of the switching elements SW5, SW6 are connected to each other.

When the power supply relay 74 is closed, the terminal voltage of the battery 60 is applied to the first inductor 72a. A smoothing capacitor 73 is connected to the output terminal of the first power conversion circuit 72. Thus, an output voltage of the first power conversion circuit 72 is applied to the smoothing capacitor 73. A terminal that is not connected to the output terminal out of two terminals of the smoothing capacitor 73 is connected to the ground terminal TG.

The first power conversion circuit 72 is a circuit that converts the terminal voltage of the battery 60 to generate an output voltage. Specifically, the switching elements SW1 to SW4 and the first inductor 72a of the first power conversion circuit 72 constitute a buck-boost chopper circuit that receives the terminal voltage of the battery 60 as an input voltage.

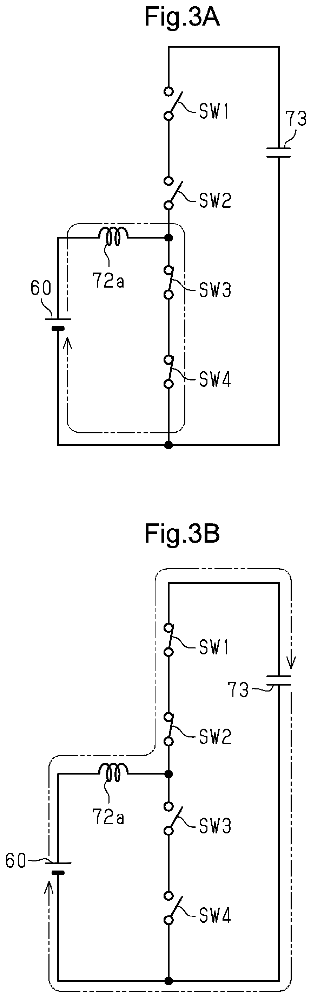

FIGS. 3A and 3B show an operation of the first power conversion circuit 72 as the buck-boost chopper circuit that receives the terminal voltage of the battery 60 as an input voltage. FIG. 3A shows a state in which the switching elements SW1, SW2 are turned OFF and the switching elements SW3, SW4 are turned ON. In this case, a first loop path formed by the battery 60, the first inductor 72a, and the switching elements SW3, SW4 is closed. Thus, a current flowing from the positive terminal of the battery 60 to the first inductor 72a gradually increases.

FIG. 3B shows a state in which the switching elements SW1, SW2 are turned ON and the switching elements SW3, SW4 are turned OFF. In this case, a second loop path including the battery 60, the first inductor 72a, and the switching elements SW1, SW2 is closed. The second loop path includes the output terminal of the first power conversion circuit 72. Therefore, the second loop path is a path including a member outside the first power conversion circuit 72. For example, the second loop path includes the smoothing capacitor 73. Thus, a current flows from the positive electrode of the battery 60 to the smoothing capacitor 73 via the first inductor 72a. At this time, the current flowing through the first inductor 72a gradually decreases.

Returning to FIG. 2, the first power conversion circuit 72 is a circuit that converts a charged voltage of a capacitor 82 to generate an output voltage. More specifically, the switching elements SW1 to SW4 and the second inductor 72b of the first power conversion circuit 72 constitute a buck-boost chopper circuit that receives the charged voltage of the capacitor 82 as an input voltage. The capacitor 82 is a lithium-ion capacitor. The upper limit of the charged voltage of the capacitor 82 is, for example, lower than the terminal voltage of the battery 60. The fully charged charge amount of the capacitor 82 is, for example, smaller than the fully charged charge amount of the battery 60.

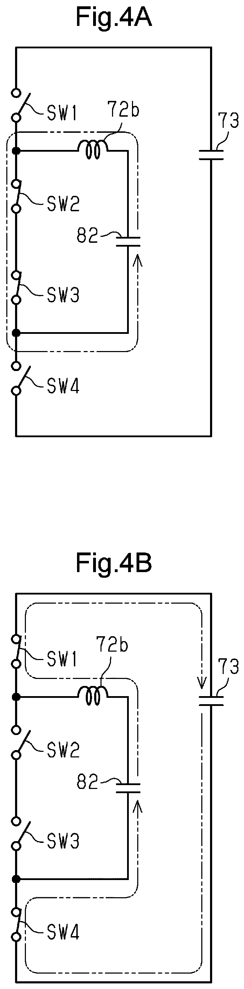

FIGS. 4A and 4B show an operation of the first power conversion circuit 72 as the buck-boost chopper circuit that receives the charged voltage of the capacitor 82 as an input voltage. FIG. 4A shows a state in which the switching elements SW2, SW3 are turned ON and the switching elements SW1, SW4 are turned OFF. In this case, a third loop path formed by the capacitor 82, the second inductor 72b, and the switching elements SW2, SW3 is closed. Thus, a current flowing from the positive electrode of the capacitor 82 to the second inductor 72b gradually increases.

FIG. 4B shows a state in which the switching elements SW1, SW4 are turned ON and the switching elements SW2, SW3 are turned OFF. In this case, a fourth loop path including the capacitor 82, the second inductor 72b, and the switching elements SW1, SW4 is closed. The fourth loop path includes the output terminal of the first power conversion circuit 72. Therefore, the fourth loop path is a path including a member outside the first power conversion circuit 72. For example, the fourth loop path includes the smoothing capacitor 73. Thus, a current flows from the positive electrode of the capacitor 82 to the smoothing capacitor 73 via the second inductor 72b. At this time, the current flowing through the second inductor 72b gradually decreases.

Returning to FIG. 2, the output terminal of the first power conversion circuit 72 is connected to the power terminal TP. The smoothing capacitor 73 is connected between the ground terminal TG and the power terminal TP. That is, the smoothing capacitor 73 is connected in parallel to the reaction inverter 18 and the steering inverter 36. Therefore, the second loop circuit and the fourth loop circuit can also be regarded as paths including the reaction inverter 18 and the steering inverter 36.

A node N1 between the output terminal of the first power conversion circuit 72 and the power terminal TP is connected to the power supply terminal TS via a bypass relay 76 that is a switch. The bypass relay 76 is a switch that opens and closes the electrical path between the power supply terminal TS and the node N1. Therefore, when the bypass relay 76 is closed, the terminal voltage of the battery 60 is applied to the node N1. The electrical path between the power supply terminal TS, the bypass relay 76, and the node N1 constitutes a bypass path that bypasses the first power conversion circuit 72 and connects the battery 60 to the power terminal TP.

The bypass relay 76 is a normally closed relay. The bypass relay 76 is formed by connecting switching elements SW7, SW8 in series. The switching elements SW7, SW8 are P-channel field effect transistors. The anodes of a body diode of the switching element SW7 and a body diode of the switching element SW8 are connected to each other. Voltages of pre-drivers 78, 80 are applied to the gates of the switching elements SW7, SW8.

The pre-driver 78 uses the capacitor 82 as a power supply. The pre-driver 78 opens and closes the bypass relay 76 by causing a potential difference between the gate and the source or between the gate and the drain of each of the switching elements SW7, SW8. The pre-driver 78 includes a circuit that performs switching as to which of the two portions that are the negative electrode of the capacitor 82 and a point having a higher potential than the negative electrode is to be connected to the gates of the switching elements SW7, SW8. The point having a higher potential may be the positive electrode of the capacitor 82. The point having a higher potential may be a point having a higher potential than the positive electrode of the capacitor 82. The point having a higher potential than the positive electrode of the capacitor 82 can be realized, for example, by providing the pre-driver 78 with a charge pump that boosts the charged voltage of the capacitor 82.

The pre-driver 80 uses the battery 60 as a power supply. The pre-driver 80 opens and closes the bypass relay 76 by causing a potential difference between the gate and the source or between the gate and the drain of each of the switching elements SW7, SW8. The pre-driver 80 includes a circuit that performs switching as to which of the two portions that are the negative electrode of the battery 60 and a point having a higher potential than the negative electrode is to be connected to the gates of the switching elements SW7, SW8. The point having a higher potential may be the positive electrode of the battery 60. The point having a higher potential may be a point having a higher potential than the positive electrode of the battery 60. The point having a higher potential than the positive electrode of the battery 60 can be realized, for example, by providing the pre-driver 80 with a charge pump that boosts the terminal voltage of the battery 60.

The charged voltage of the capacitor 82 is applied to a second power conversion circuit 84. The second power conversion circuit 84 is a circuit that boosts the charged voltage of the capacitor 82. Specifically, the second power conversion circuit 84 is a boost chopper circuit. Specifically, the second power conversion circuit includes an inductor 84a connected to an input terminal, and a diode 84b having an anode connected to the inductor 84a. The cathode of the diode 84b serves as an output terminal of the second power conversion circuit 84. The anode of the diode 84b is connected to the ground terminal TG via a switching element SW9.

A capacitor 85 is provided between the output terminal of the second power conversion circuit 84 and the ground terminal TG. The output voltage of the second power conversion circuit 84 and the voltage applied to the power supply terminal TS are input to an OR circuit 86. The OR circuit 86 outputs a logical sum voltage of the input voltages. That is, when the two input voltages are not equal, the OR circuit 86 outputs the larger of them. When the two input voltages are equal, the OR circuit 86 outputs the input voltage. The voltage applied to the power supply terminal TS is input to the OR circuit 86 via the power supply relay 74.

Specifically, the OR circuit 86 includes diodes 86a, 86b. The diode 86a has an anode connected to the power supply terminal TS and a cathode connected to the control terminal TC. The diode 86b has an anode connected to the output terminal of the second power conversion circuit 84 and a cathode connected to the control terminal TC.

A control unit 88 that is a processing circuit is hardware in which the output voltage of the power supply circuit 70 is the controlled variable. The control unit 88 may include, for example, a PU and a storage device. The PU is a software processing device such as a CPU, a GPU, and a TPU. The storage device may be a non-volatile memory that is not rewritable electrically. The storage device may also be an electrically rewritable non-volatile memory, a disc medium, or other storage media. The control unit 88 is not limited to a unit that performs software processing. For example, the control unit 88 may include a dedicated hardware circuit such as an ASIC.

The control unit 88 operates the switching elements SW1 to SW9 to control the output voltage of the power supply circuit 70.

### "Operations of Power Supply Circuit 70"

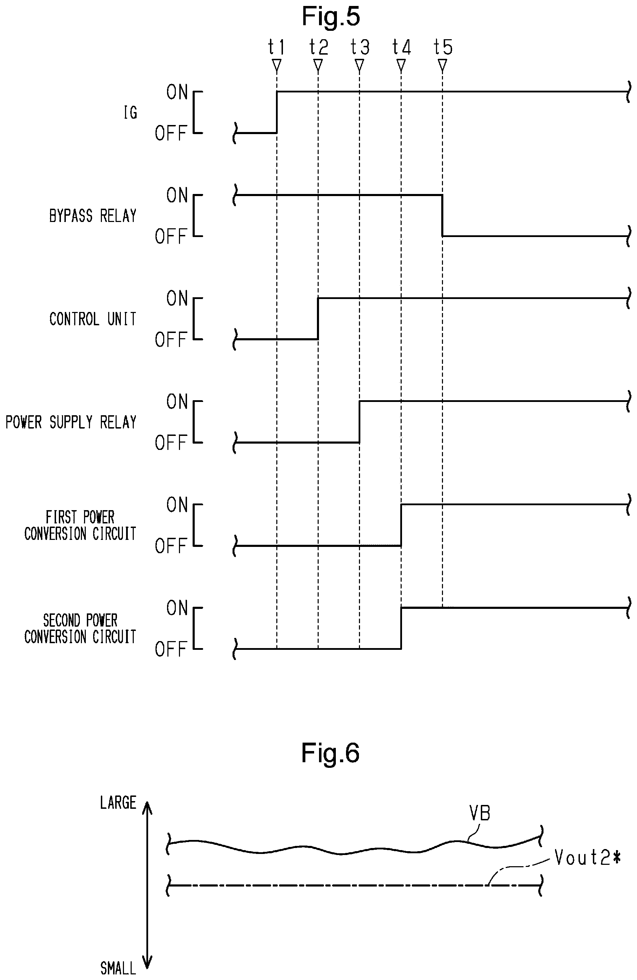

FIG. 5 shows operations of the power supply circuit 70.

FIG. 5 shows an example in which the IG signal is turned ON at time t1. In other words, FIG. 5 shows a state in which the traveling permission signal is ON, that is, the traveling is permitted. After the IG signal is turned ON, the control unit 88 is turned ON at time t2. When the control unit 88 is turned ON, the control unit 88 first turns ON the power supply relay 74 at time t3. Then, the control unit 88 starts driving the first power conversion circuit 72 and the second power conversion circuit 84 at time t4.

When the battery 60 is normal, the control unit 88 outputs the electric power of the battery 60 via the first power conversion circuit 72 through the process shown in FIG. 3. When an abnormality occurs as in a case where the terminal voltage of the battery 60 is not applied to the power supply terminal TS or when the battery 60 cannot fully supply the electric power, the control unit 88 outputs the electric power of the capacitor 82 via the first power conversion circuit 72 through the process shown in FIG. 4.

As shown in FIG. 6, the control unit 88 sets a command value Vout2* of an output voltage Vout2 of the second power conversion circuit 84 to a value lower than a terminal voltage VB of the battery 60. Therefore, when the terminal voltage VB of the battery 60 is applied to the power supply terminal TS, the OR circuit 86 outputs the voltage applied to the power supply terminal TS. That is, in this case, the electric power output from the OR circuit 86 is the output power of the battery 60. Therefore, the power consumption of the capacitor 82 can be reduced.

Returning to FIG. 5, the control unit 88 switches the bypass relay 76 to the OFF state at time t5. In other words, the bypass relay 76 is switched to a state.

### <Functions and Effects of Embodiment>

Functions and effects of the present embodiment will be described.

The electric power of the battery 60 and the charged power of the capacitor 82 are input to the first power conversion circuit 72. Therefore, even if an abnormality occurs in, for example, the battery 60, the charged power of the capacitor 82 can be supplied to the reaction force control unit 40 and the steering control unit 50.

In the first power conversion circuit 72, the circuit portion in which the battery 60 is an input and the circuit portion in which the capacitor 82 is an input share the switching elements SW1 to SW4. This contributes to reducing the number of components.

If an abnormality occurs in the switching elements SW1 to SW4, there is a risk that the electric power of the battery 60 and the charged power of the capacitor 82 cannot be supplied to the reaction force control unit 40 and the steering control unit 50.

Therefore, the power supply circuit 70 includes the bypass relay 76. The bypass relay 76 bypasses the first power conversion circuit 72 and connects the positive electrode of the battery 60 and the power terminal TP. Therefore, even if the first power conversion circuit 72 does not operate normally, the electric power of the battery 60 can be supplied to the reaction inverter 18 and the steering inverter 36.

The embodiment described above further has the following functions and effects.

(1-1) The bypass relay 76 is the normally closed relay. Thus, the electric power can quickly be supplied to the reaction inverter 18 and the steering inverter 36 after the IG signal is switched to the ON state.

That is, as shown in FIG. 5, when the IG signal is switched to the ON state, the power supply relay 74 is closed and then the first power conversion circuit 72 is driven. Therefore, after the IG signal is switched to the ON state, a delay occurs before the output voltage of the first power conversion circuit 72 is applied to the reaction inverter 18 and the steering inverter 36. In the present embodiment, the bypass relay 76 is of the normally closed type. Therefore, when the IG signal is switched, the terminal voltage of the battery 60 is applied to the reaction power supply relay 46. When the IG signal is switched, the terminal voltage of the battery 60 is also applied to the steering power supply relay 56. Thus, when the IG signal is switched, the terminal voltage of the battery 60 can be applied to the reaction inverter 18 and the steering inverter 36 via the bypass relay 76 as quickly as possible.

(1-2) The bypass relay 76 is formed by the series connection of the pair of switching elements SW7, SW8, and the forward directions of their body diodes are opposite to each other. Thus, it is possible to suppress a flow of a current between the battery 60 and the power terminal TP via the body diodes when the bypass relay 76 is OFF.

(1-3) The drive circuits of the bypass relay 76 are the pre-drivers 78, 80 with different power supplies. Therefore, the bypass relay 76 can be operated even if an abnormality occurs in either the battery 60 or the capacitor 82.

(1-4) The negative electrode of the battery 60 is connected to the reaction force control unit 40 and the steering control unit 50 via the ground line LG that bypasses the housing Ha that houses the power supply circuit 70. Thus, the number of terminals of the connector of the power supply circuit 70 can be reduced. That is, the number of terminals of the power supply circuit 70 increases if a terminal connected to the ground terminal TG is provided in the power supply circuit 70 and the negative electrode of the battery 60 is connected to the reaction force control unit 40 and the steering control unit 50 via this terminal.

Further, the constraints on the channel sectional area of the ground line LG are less stringent than the constraints on the channel sectional area of the line in the power supply circuit 70. Therefore, the electrical resistance between the negative electrode of the battery 60 and the reaction force control unit 40 and between the negative electrode of the battery 60 and the steering control unit 50 can be reduced. Thus, the efficiency of power usage can be improved.

(1-5) The electric power of the battery 60 and the electric power of the capacitor 82 can be supplied to the control terminal TC. Therefore, even if an abnormality occurs in either the battery 60 or the capacitor 82, the electric power can be supplied to the reaction force control unit 40 and the steering control unit 50 via the control terminal TC.

(1-6) The output voltage of the second power conversion circuit 84 that boosts the charged power of the capacitor 82 can be output to the control terminal TC. Thus, it is possible to apply a necessary voltage to the control terminal TC even if the charged voltage of the capacitor 82 is low.

(1-7) Even if the electric power of the capacitor 82 is not used, the control unit 88 drives the second power conversion circuit 84 while controlling the output voltage of the second power conversion circuit 84 to a voltage lower than the terminal voltage of the battery 60. Thus, it is possible to suppress reset of the reaction microcomputer 44 and the steering microcomputer 54 when an abnormality occurs in the battery 60.

That is, if the second power conversion circuit 84 is stopped when the electric power of the capacitor 82 is not used, the voltage of the control terminal TC temporarily decreases significantly in the event of an abnormality as in the case where the terminal voltage of the battery 60 is not applied to the power supply terminal TS. Therefore, there is a risk that the reaction microcomputer 44 and the steering microcomputer 54 are reset. In the present embodiment, the second power conversion circuit 84 is driven in advance. Therefore, the output voltage of the second power conversion circuit 84 is immediately applied to the control terminal TC when the terminal voltage of the battery 60 is not applied to the power supply terminal TS. Thus, it is possible to continue the operations of the reaction microcomputer 44 and the steering microcomputer 54.

(1-8) The power supply relay 74 is provided between the battery 60 and the first power conversion circuit 72. Thus, it is possible to suppress an outflow of the electric power of the battery 60 to the power terminal TP via the first power conversion circuit 72 while the first power conversion circuit 72 is stopped. That is, if the power supply relay 74 is not provided, there is a risk that a current flows from the positive electrode of the battery 60 to the power terminal TP via the body diodes of the switching elements SW1, SW2 while the first power conversion circuit 72 is stopped.

(1-9) The power supply relay 74 is formed by the two switching elements SW5, SW6 whose body diodes are connected in opposite directions. Thus, it is possible to suppress a flow of a current from the battery 60 to the body diodes of the first power conversion circuit 72 while the first power conversion circuit 72 is stopped both when the battery 60 is connected correctly and when the battery 60 is connected in reverse polarity. That is, when the battery 60 is connected in reverse polarity, the body diodes of the switching elements SW3, SW4 are in the forward direction in the path including the switching elements SW3, SW4, the first inductor 72a, and the battery 60. Therefore, if the power supply relay 74 cannot open the loop path, the loop path is in a closed loop state.

### <Second Embodiment>

A second embodiment will be described below with reference to the drawings, focusing on the differences from the first embodiment.

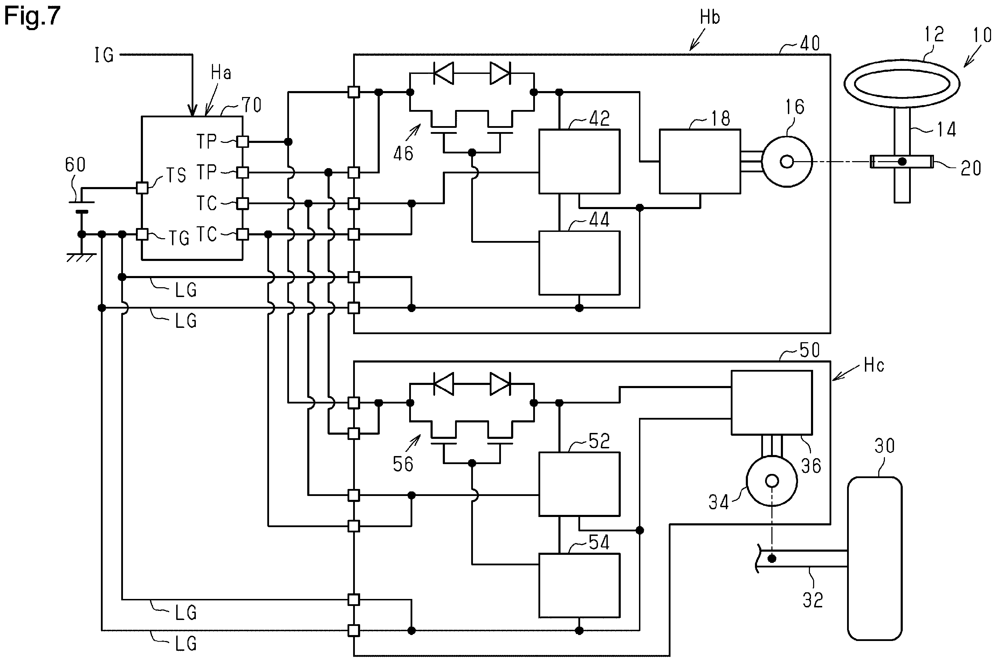

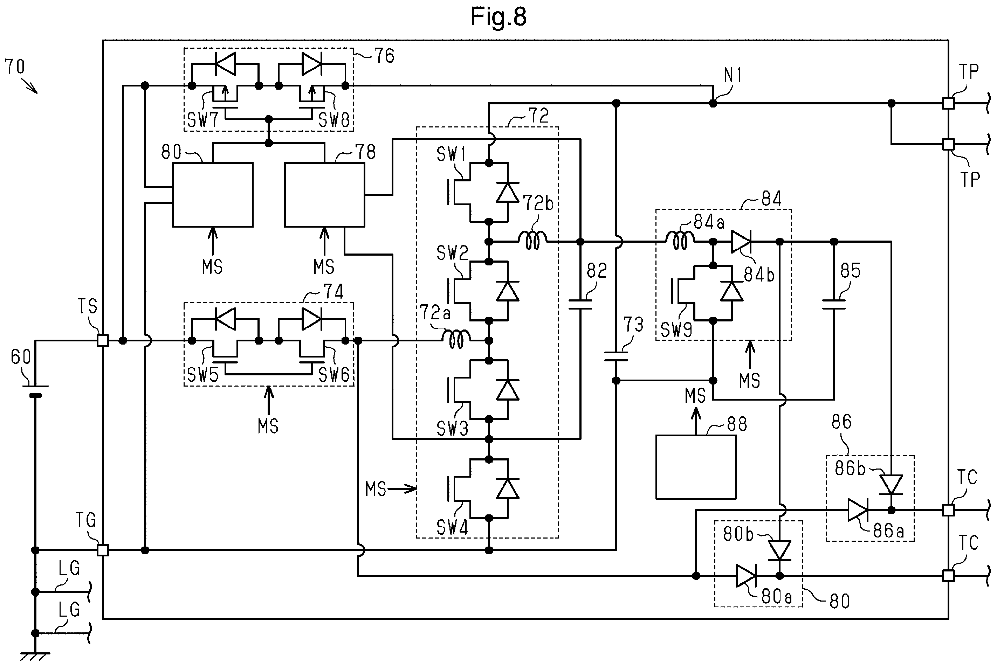

FIGS. 7 and 8 show the configuration of a power supply system according to the present embodiment. In FIGS. 7 and 8, the members corresponding to those shown in FIGS. 1 and 2 are denoted by the same signs for convenience.

As shown in FIGS. 7 and 8, the negative terminal of the battery 60 is connected to the reaction force control unit 40 and the steering control unit 50 via two ground lines LG. That is, redundancy is provided in the electrical path of the ground potential between the battery 60 and the reaction force control unit 40 and between the battery 60 and the steering control unit 50. Thus, it is possible to provide the reaction force control unit 40 and the steering control unit 50 with the ground potential more stably.

Further, the electric power can be supplied to the reaction force control unit 40 and the steering control unit 50 more reliably even if the connection between the ground terminal TG and the negative electrode of the battery 60 is interrupted. That is, the loop path including the bypass relay 76, the reaction inverter 18 (steering inverter 36), the ground line LG, and the battery 60 can be brought into a closed loop more reliably. In addition, the path including the battery 60, the power supply terminal TS, the control terminal TC, the reaction microcomputer 44 (steering microcomputer 54), and the ground line LG can be brought into a closed loop more reliably.

The power supply circuit 70 includes two power terminals TP. Specifically, as shown in FIG. 8, the output terminal of the first power conversion circuit 72 is connected to two different power terminals TP. The bypass relay 76 is also connected to the two different power terminals TP. The two power terminals TP are connected to the reaction force control unit 40 and the steering control unit 50. That is, redundancy is provided in the distribution paths of the output power of the battery 60 and the first power conversion circuit 72 between the power supply circuit 70 and the reaction force control unit 40 and between the power supply circuit 70 and the steering control unit 50. Thus, the output power of the battery 60 and the first power conversion circuit 72 can be supplied to the reaction force control unit 40 and the steering control unit 50 more stably.

The power supply circuit 70 further includes two control terminals TC. Specifically, as shown in FIG. 8, the power supply circuit 70 includes two OR circuits 86. The voltage of the power supply terminal TS and the output voltage of the second power conversion circuit 84 are applied to each of the OR circuits 86. The output voltages of the two OR circuits 86 are connected to different control terminals TC.

The two control terminals TC are connected to the reaction force control unit 40 and the steering control unit 50. That is, redundancy is provided in the distribution paths of the output power of the battery 60 and the capacitor 82 between the power supply circuit 70 and the reaction force control unit 40 and between the power supply circuit 70 and the steering control unit 50. Thus, the output power of the battery 60 and the capacitor 82 can be supplied to the reaction force control unit 40 and the steering control unit 50 more stably.

### <Other Embodiments>

The embodiments can be modified as follows. The embodiments and the following modifications can be combined as long as no technical contradictions arise.

### "Regarding Switch"

- The switch is not limited to the two P-channel field effect transistors with the anodes of the body diodes connected together. The switch may be, for example, two P-channel field effect transistors with the cathodes of the body diodes connected together.
- The voltage-controlled switching element constituting the switch is not limited to the P-channel field effect transistor. For example, an N-channel field effect transistor may be used. In this case, for example, a path that opens and closes a path connecting the gate of the N-channel field effect transistor and the positive terminal of the battery 60 may be formed by a P-channel field effect transistor. Thus, the switch can be of a normally closed type.
- The conduction control terminals of the two voltage-controlled switching elements constituting the switch need not be short-circuited. In this case, for example, the drive of the first power conversion circuit 72 may be started and a switching element including a body diode in which the direction from the battery 60 to the power terminal TP is the forward direction may be selectively turned OFF. In this case, a switching element including a body diode in which the direction from the battery 60 to the power terminal TP is the reverse direction may be turned OFF after the output of the first power conversion circuit 72 is stabilized.
- It is not essential that the switch is formed by the two voltage-controlled switching elements. For example, the switch may be formed by a series connection of three or more voltage-controlled switching elements. In this case, the forward directions of the body diodes are set different from each other. For example, the switch may be formed by one voltage-controlled switching element. For example, an insulated gate bipolar transistor may be adopted as the single voltage-controlled switching element constituting the switch. For example, a P-channel field effect transistor may also be adopted as the single voltage-controlled switching element constituting the switch. Specifically, the bypass relay 76 may be formed by, for example, only the switching element SW7. In this case, for example, the voltage-controlled switching element may be provided between the node N1 and the output terminal of the first power conversion circuit 72. The body diode of this switching element may have a cathode connected to the output terminal of the first power conversion circuit 72.
- It is not essential that the switching element constituting the switch is the voltage-controlled switching element. For example, a current-controlled switching element such as a bipolar transistor may be adopted.
- The semiconductor element constituting the switch is not limited to the transistor. For example, the semiconductor element may be a thyristor.
- It is not essential that the switch is formed by the semiconductor element. For example, the switch may include an electromagnetic relay. Even in this case, it is desirable to adopt a normally closed electromagnetic relay.
- It is not essential that the switch is of the normally closed type. "Regarding Drive Circuit of Switch"
- The terminal of the pre-driver 78 may be connected to the ground terminal TG instead of being connected to the connection point between the switching elements SW3, SW4.
- The drive circuit of the switch is not limited to the pre-driver 78 using the capacitor 82 as a power supply and the pre-driver 80 using the battery 60 as a power supply. For example, only one of the pre-drivers 78, 80 may be provided as the drive circuit.

### "Regarding Power Supply Relay"

- The power supply relay is not limited to the two N-channel field effect transistors with the anodes of the body diodes connected together as exemplified by the power supply relay 74. The switch may be, for example, two N-channel field effect transistors with the cathodes of the body diodes connected together.
- The voltage-controlled switching element constituting the power supply relay is not limited to the N-channel field effect transistor. For example, a P-channel field effect transistor may be used. In this case, for example, a path that opens and closes a path connecting the gate of the P-channel field effect transistor and the positive terminal of the battery 60 may be formed by a P-channel field effect transistor. Thus, the switch can be of a normally open type.
- It is not essential that the power supply relay is formed by the two voltage-controlled switching elements. For example, the power supply relay may be formed by a series connection of three or more voltage-controlled switching elements. In this case, the forward directions of the body diodes are set different from each other. For example, the power supply relay may be formed by one voltage-controlled switching element. For example, an insulated gate bipolar transistor may be adopted as the single voltage-controlled switching element constituting the power supply relay.
- It is not essential that the switching element constituting the power supply relay is the voltage-controlled switching element. For example, a current-controlled switching element such as a bipolar transistor may be adopted.
- The semiconductor element constituting the power supply relay is not limited to the transistor. For example, the semiconductor element may be a thyristor.
- It is not essential that the power supply relay is formed by the semiconductor element. For example, the power supply relay may include an electromagnetic relay. Even in this case, it is desirable to adopt a normally open electromagnetic relay.

### "Regarding First Power Conversion Circuit"

- It is not essential that the switching elements SW1 to SW4 constituting the first power conversion circuit 72 are the field effect transistors. For example, an insulated gate bipolar transistor may be adopted. In this case, freewheel diodes may be connected in parallel to the switching elements SW1 to SW4.
- It is not essential that the first power conversion circuit 72 includes the four switching elements SW1 to SW4. For example, the first power conversion circuit 72 may be a circuit in which the switching element SW1 is replaced with a diode. In this case, the circuit portion of the first power conversion circuit 72 that receives the electric power of the battery 60 as an input is a boost chopper circuit that receives the electric power of the battery 60 as an input. In this case, the circuit portion of the first power conversion circuit 72 that receives the electric power of the capacitor 82 as an input is a boost chopper circuit that receives the electric power of the capacitor 82 as an input.
- The supply destination of the output power of the first power conversion circuit is not limited to the actuator system. For example, the output power may also be supplied to the control system.

### "Regarding Second Power Conversion Circuit"

- It is not essential that the second power conversion circuit 84 is the boost chopper circuit. The second power conversion circuit 84 may be, for example, a buck-boost chopper circuit. For example, the second power conversion circuit 84 may also be a charge pump.

### "Regarding Electrical Path That Bypasses Housing Ha That Houses Power Supply Circuit"

- The electrical path that bypasses the housing Ha that houses the power supply circuit 70 is not limited to one or two ground lines LG. For example, three or more ground lines LG may be adopted.

### "Regarding First Direct-current Voltage Source"

- It is not essential that the first direct-current voltage source is the battery 60. For example, the first direct-current voltage source may be a capacitor. In this case, it is desirable that the capacitor be provided between the output terminal of the power conversion circuit connected to the secondary battery and the ground. Thus, the capacitor can charge the electric power of the secondary battery. The secondary battery may be, for example, a secondary battery that supplies electric power to a main device mounted on an electric vehicle.

### "Regarding Second Direct-current Voltage Source"

- The capacitor 82 is not limited to the lithium-ion capacitor. For example, an aluminum electrolytic capacitor may be adopted.
- It is not essential that the second direct-current voltage source is the capacitor 82. For example, the second direct-current voltage source may be a secondary battery.
- It is not essential that the fully charged charge amount of the second direct-current voltage source is smaller than the fully charged charge amount of the first direct-current voltage source.
- It is not essential that the terminal voltage of the second direct-current voltage source is smaller than the terminal voltage of the first direct-current voltage source.

### "Regarding Power System Electrical Load"

- The power system electrical load is not limited to the reaction inverter 18 and the steering inverter 36. For example, in a configuration in which the power of the steering wheel 12 can be transmitted to the steered wheel 30, the electrical load may be a drive circuit of an assist motor that generates a torque to assist the operation on the steering wheel 12.
- It is not essential that the power system electrical load is the electrical load of the actuator of the steering system of the vehicle.

### "Others"

- It is not essential that the power supply circuit 70 includes the smoothing capacitor 73.

## Claims

1. A power supply circuit comprising:
a power conversion circuit configured to apply an output voltage to an electrical load; and
a bypass path, wherein
the power conversion circuit is configured such that a terminal voltage of a first direct-current voltage source and a terminal voltage of a second direct-current voltage source are applied, and includes a first inductor, a second inductor, and a plurality of switching elements,
the plurality of switching elements is configured to open and close a first loop path, a second loop path, a third loop path, and a fourth loop path,
the plurality of switching elements that opens and closes the first loop path and the second loop path and the plurality of switching elements that opens and closes the third loop path and the fourth loop path are common elements,
the first loop path is a path that includes the first direct-current voltage source and the first inductor and does not include an output terminal of the power conversion circuit,
the second loop path is a path that includes the first direct-current voltage source, the first inductor, and the output terminal of the power conversion circuit,
the third loop path is a path that includes the second direct-current voltage source and the second inductor and does not include the output terminal of the power conversion circuit,
the fourth loop path is a path that includes the second direct-current voltage source, the second inductor, and the output terminal of the power conversion circuit, and
the bypass path is a path that bypasses the power conversion circuit and connects the first direct-current voltage source and the electrical load, and includes a switch that opens and closes the bypass path.

2. The power supply circuit according to claim 1, wherein the switch is a normally closed switch.

3. The power supply circuit according to claim 1, wherein:
the switch is a voltage-controlled switching element;
the power supply circuit includes a drive circuit that drives the switch; and
the drive circuit uses both the first direct-current voltage source and the second direct-current voltage source as power supplies.

4. The power supply circuit according to claim 1, further comprising a control unit, wherein the control unit is configured to perform a process of switching the switch to an open state after drive of the power conversion circuit is started.

5. The power supply circuit according to claim 4, further comprising a power supply relay, wherein:
the power supply relay is configured to open and close a point between the first direct-current voltage source and the power conversion circuit; and
the control unit is configured to perform a process of driving the power conversion circuit after the power supply relay is closed.

6. The power supply circuit according to claim 1, wherein:
each of the plurality of switching elements includes a body diode in which a direction from a positive electrode of the first direct-current voltage source to the electrical load is a forward direction;
the power supply circuit includes a power supply relay; and
the power supply relay is a relay that opens and closes a point between the first direct-current voltage source and the power conversion circuit.

7. A power supply system comprising the power supply circuit according to claim 1 and the electrical load, wherein:
the power supply circuit and the electrical load are housed in different housings; and
the power supply system includes an electrical path that connects a negative electrode of the first direct-current voltage source and the electrical load while bypassing the housing that houses the power supply circuit.

8. The power supply system according to claim 7, wherein the power supply system includes a plurality of the electrical paths that makes connection while bypassing the housing that houses the power supply circuit.

9. The power supply system according to claim 7, wherein the switch is connected to the electrical load via a plurality of electrical paths outside the housing that houses the power supply circuit.

10. The power supply system according to claim 7, wherein:
the power supply system is mounted on a vehicle;
in the vehicle, a process of operating a steered wheel in response to an operation on a steering wheel is performed in a state in which power transmission between the steering wheel and the steered wheel is interrupted;
the electrical load includes a reaction motor and a steering motor;
the reaction motor is configured to apply a force resisting rotation of the steering wheel; and
the steering motor is configured to steer the steered wheel.
